# EUROPÄISCHE PATENTANMELDUNG

(11) **EP 0 848 206 A2**
(43) Veröffentlichungstag der Anmeldung: **17.06.1998**
(21) Anmeldenummer: 97121076.0
(22) Anmeldetag: 01.12.1997
(51) Int. Cl.: F21P 5/00, F21K 7/00

(54) **Vorrichtung zur Beleuchtung von Theaterbühnen, TV-Studios od. dgl.**

(30) Priorität: 12.12.1996 DE 29621619 U
(71) Anmelder: SIEMENS AKTIENGESELLSCHAFT, 80333 München (DE)
(72) Erfinder: Goerke, Reinhard, Dr., 1030 Brüssel (BE)

(57) **Zusammenfassung**

Mit einer Vorrichtung zur Beleuchtung von Theaterbühnen, TV-Studios und anderen, möglichst gleichmäßig zu beleuchtenden Räumen, soll eine Lösung geschaffen werden, mit der zum einen die Probleme mit der Wärmeentwicklung stark verringert werden, mit der ebenso aber auch beliebige Emissionsfarben der Beleuchtung ermöglicht werden. Dies wird dadurch erreicht, daß die die Beleuchtung abgebende Fläche (3) von einer organischen Leuchtdiode (LED) als Flächenelement gebildet ist.

## Beschreibung

Die Erfindung richtet sich auf eine Vorrichtung zur Beleuchtung von Theaterbühnen, TV-Studios und anderen, möglichst gleichmäßig zu beleuchtenden Räumen.

Ein wesentliches Problem bei derartigen Beleuchtungen von Bühnen in Fernsehstudios u. dgl. ist die große Wärmeentwicklung durch die Scheinwerfer. Auch sind zum Teil erhebliche Aufwendungen notwendig, um bestimmte Farben in der Beleuchtung zu erzielen, hier werden Farbfilter in Vorsätzen benutzt, um nur ein Beispiel zu nennen.

Je nach Einsatzzweck ist bereits bekannt, sogenannte Flächenleuchten einzusetzen mit Halogenglühlampen und großen Reflektoren oder Leuchtstofflampen, bei denen sogenannte "Soft-Leit"-Leuchten eingesetzt werden. Dabei ist auch bekannt, farbige Leuchtstofflampen, Rot, Grün, Blau oder Weiß, für Hintergrundbeleuchtung zu verwenden. Um eine beliebige Farbmischung (RGB) zu erzielen, arbeitet man mit Glas-, Folien-, Dichroid-Filtern od. dgl.

Aufgabe der Erfindung ist die Schaffung einer Lösung, mit der zum einen die Probleme mit der Wärmeentwicklung stark verringert werden, mit der ebenso aber auch beliebige Emissionsfarben der Beleuchtung ermöglicht werden.

Mit einer Vorrichtung der eingangs bezeichneten Art wird diese Aufgabe gemäß der Erfindung dadurch gelöst, daß die die Beleuchtung abgebende Fläche von einer organischen Leuchtdiode (LED) als Flächenelement gebildet ist.

Das Vorsehen einer organischen Leuchtdiode (LED = light emitting diode) bringt eine Fülle von Vorteilen mit sich. So kann eine polymere LED großflächig hergestellt werden, die jeweilige Emissionsfarbe kann frei gewählt werden und durch die möglishe Biegsamkeit der LED sind eine Vielzahl von konstruktiven Lösungen denkbar. So kann die Emissionsfarbe korrekt auf die RGB-Sensibilität der derzeitigen TV-Kameratechnik angepaßt werden, was bei Leuchtstofflampenlicht derzeit nicht möglich ist. Durch ihre Biegsamkeit kann eine derartige Leuchte als Horizontbeleuchtung eines Fernsehstudios eingesetzt werden. Aufwendige Reflektorentwicklungen für die Beleuchtung sind nicht mehr erforderlich.

Anorganische Halbleitermaterialien werden in jüngerer Zeit durch organische Materialien ausgetauscht, wobei eine derartige organische Anordnung in der Regel aus einem Trägersubstrat, einer Basiselektrode, einer Löcher injizierenden, einer Löcher transportierenden sowie einer Emitterschicht gebildet sind mit einer Elektronen transportierenden und einer Elektronen injizierenden Schicht, einer Top-Elektrode, den entsprechenden Kontakten sowie einer Umhüllung oder Verkapselung.

Es ist auch bekannt, daß eine oder mehrere Schichten dadurch weggelassen werden können, daß andere Schichten mehrere der oben genannten Aufgaben übernehmen, wobei der einfachste Aufbau darin besteht, daß zwei Elektroden vorgesehen sind, zwischen denen sich eine organische Schicht befindet, die alle Funktionen inklusive der Emission von Licht erfüllt (WO 90/13148).

Weitere Ausgestaltungen der Erfindung ergeben sich aus den Unteransprüchen. So sieht die Erfindung insbesondere vor, daß als organische LED eine Schicht aus einem konjugierten Polymer, insbesondere Polyphenylenvinylen (PPV) vorgesehen ist.

Den Besonderheiten des Bühnen- bzw. Studioeinsatzes trägt die Erfindung dadurch Rechnung, daß die informationstragende Fläche von einem Glas-Substrat gebildet wird mit darauf aufgebrachtem PPV zwischen wenigstens einer transparenten und einer metallischen Elektrode, wobei in Ausgestaltung als organische LED auf einem Glas-Substrat mit einer transparenten Elektrode eine Löcher transportierende Schicht (hole Transport layer (TPD)) mit einem emitting layer (AlQ3) und einer Metallelektrode vorgesehen ist. Mit der Erfindung lassen sich beleuchtbare Raumstrukturen erzielen, leuchtende dreidimensionale Körper mit entsprechend ausgestalteter Oberfläche u. dgl. mehr.

Zur Erzeugung unterschiedlicher Farben kann jeder Vorrichtung ein eigener Spannungsregler zugeordnet sein, wie dies die Erfindung ebenfalls vorsieht, wobei in weiterer Ausgestaltung vorgesehen sein kann, daß zur gleichzeitigen Erzeugung unterschiedlicher Farben je Farbe eine getrennte Matrix ansteuerbar ist, die von nebeneinander und/oder übereinander gelagerten Schichten bzw. Gittern gebildet sind.

Durch die erfindungsgemäße Variante, die Beleuchtungskörper als Steckmodule zum Zusammenfügen in gemeinsamen Tragrahmen auszubilden, ist es nicht nur möglich, schachbrettartige Farbmuster oder Streifenmuster zur erzeugen, sondern eine gezielte großfläche Bilderzeugung durch kleinstrukturierte oder großstrukturierte Farbmodule.

Weitere Merkmale, Einzelheiten und Vorteile der Erfindung ergeben sich aufgrund der nachfolgenden Beschreibung sowie anhand der Zeichnung. Diese zeigt in
- FIG 1: die Gestaltung eines erfindungsgemäßen Beleuchtungskörpers,
- FIG 2 und 3: vereinfachte Schnittdarstellungen durch Vorrichtungsvarianten nach der Erfindung,
- FIG 4: eine vereinfachte räumliche Darstellung eines Beleuchtungskörpers mit mehreren erfindungsgemäßen Vorrichtungen sowie in den
- FIG 5 und 6: modular aufgebaute Beleuchtungskörper.

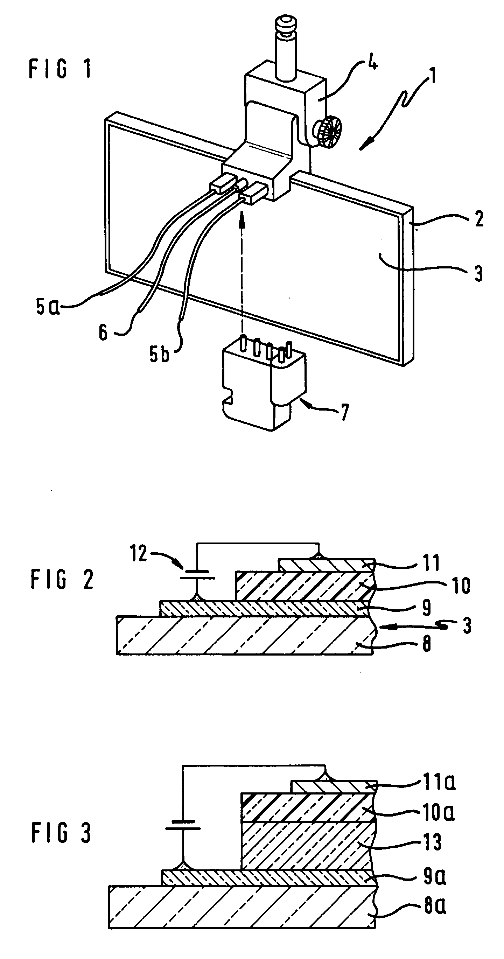

Im dargestellten Beispiel weist die allgemein mit 1 bezeichnete Vorrichtung zur Beleuchtung in einem Rahmen 2 ein Flächenelement 3, welche als lichtabgebende Leuchtdiode ausgebildet ist, auf. Im dargestellten Beispiel ist am Rahmen ein Halte- und Montageelement 4 vorgesehen mit einer Stromzuführungs- und Stromabführungsleitung 5a bzw. 5b und beispielsweise einer Steuerleitung 6. In FIG 1 ist dabei noch die Möglichkeit dargestellt, einen zusätzlichen Dimmer vorzusehen, insbesondere zur Veränderung der Farbe und/oder der Helligkeit der organischen Leuchtdiode.

Ein querschnittlich vereinfacht wiedergegebener Aufbau einer solchen organischen Leuchtdiode in zwei Varianten ist in den FIG 2 und 3 dargestellt. Dabei ist auf ein Glas-Substrat, z.B. eine Glasscheibe oder Plexiglasscheibe 8, eine transparente Elektrode 9 aufgebracht, auf der wiederum eine Schicht aus einem konjugierten Polymer (PPV) 10 vorgesehen ist, die z.B. von einer Metallelektrodenschicht 11 abgedeckt ist, die vorgesehene Spannungsquelle ist allgemein mit 12 bezeichnet.

In Abwandlung dazu zeigt FIG 3 das Glas-Substrat 8a, eine transparente Elektrode 9a, eine Löcher-transportierende Schicht 13, eine Licht-immitierende Schicht 10a (AlQ3) und wiederum eine Metallelektrode 11a. Je nach Aufgabe kann durch Veränderung der angelegten Spannung die Farbe geändert werden.

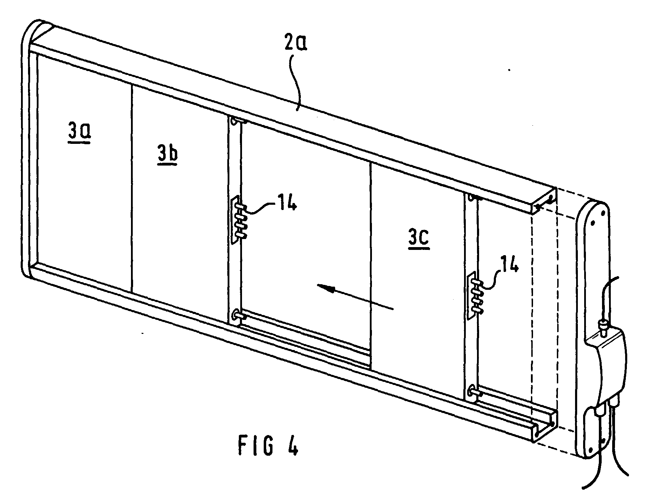

In den FIG 4 bis 6 sind mögliche Aufbauten vom Beleuchtungskörper prinzipiell dargestellt, ohne daß die Erfindung auf die dort dargestellten Konfigurationen beschränkt wäre.

So zeigt die FIG 4 den modularen Aufbau von einer Mehrzahl von Beleuchtung abgebenden Flächen 3a, 3b, 3c in einem gemeinsamen Trag- und Montagerahmen 2a, wobei über Steckeinrichtungen 14 die elektrische Kupplung der Elemente aneinander gewährleistet ist.

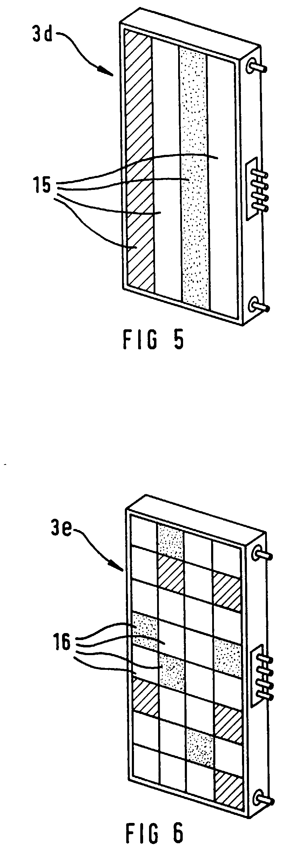

FIG 5 zeigt einen ähnlichen Aufbau in kleinerer Form, wobei ein derartiger Beleuchtungskörper 3d selbst aus unterschiedlichen Segmenten 15 bestehen kann, die aufgrund unterschiedlich angelegter Spannung unterschiedliche Farben aufweisen.

Schließlich zeigt FIG 6 einen Rasteraufbau, wobei die einzelnen Rastelemente 16 wiederum unterschiedliche Farben aufweisen können.

Natürlich sind die beschriebenen Ausführungsbeispiele der Erfindung noch in vielfacher Hinsicht abzuändern, ohne den Grundgedanken zu verlassen. So können, wenn Folienmaterialien eingesetzt werden, gebogene und gekrümmte Beleuchtungskörper erzeugt werden u. dgl. mehr.

## Patentansprüche

1. Vorrichtung zur Beleuchtung von Theaterbühnen, TV-Studios und anderen, möglichst gleichmäßig zu beleuchtenden Räumen, **dadurch gekennzeichnet,** daß die die Beleuchtung abgebende Fläche (3) von einer organischen Leuchtdiode (LED) als Flächenelement gebildet ist.

2. Vorrichtung nach Anspruch 1, **dadurch gekennzeichnet,** daß als organische LED (3) eine Schicht aus einem konjugierten Polymer, insbesondere Polyphenylenvinylen (PPV) vorgesehen ist.

3. Vorrichtung nach Anspruch 1 oder 2, **dadurch gekennzeichnet,** daß daß die informationstragende Fläche (3) von einem Glas-Substrat (9) gebildet wird mit darauf aufgebrachtem PPV zwischen wenigstens einer transparenten und einer metallischen Elektrode (11).

4. Vorrichtung nach Anspruch 1, **dadurch gekennzeichnet,** daß als organische LED auf einem Glas-Substrat (8a) mit einer transparenten Elektrode (9a) ein hole transport layer (TPD) (13) mit einem emitting layer (AlQ3) (10a) und einer Metallelektrode (11) vorgesehen ist.

5. Vorrichtung nach Anspruch 1 oder einem der folgenden, **dadurch gekennzeichnet,** daß das Glas-Trägersubstrat (8) als verformbares Folienmaterial ausgebildet ist.

6. Vorrichtung nach Anspruch 1 oder einem der folgenden, **dadurch gekennzeichnet,** daß zur Erzeugung unterschiedlicher Farben ein Spannungsregler vorgesehen ist.

7. Vorrichtung nach Anspruch 1 oder einem der folgenden, **dadurch gekennzeichnet,** daß zur gleichzeitigen Erzeugung unterschiedlicher Farben je Farbe eine getrennte Matrix ansteuerbar ist, die von nebeneinander und/oder übereinander gelagerten Schichten (15) bzw. Gittern (16) gebildet sind.

8. Vorrichtung nach Anspruch 1 oder einem der folgenden, **dadurch gekennzeichnet,** daß die Beleuchtungskörper (3a-3e) als Steckmodule zum Zusammenfügen in gemeinsame Tragrahmen (2a) od. dgl. ausgebildet sind.
